# EUROPEAN PATENT APPLICATION

(11) **EP 4 845 032 A1**
(43) Date of publication of application: **25.11.2026**
(21) Application number: 25747573.1
(22) Date of filing: 17.01.2025
(51) Int. Cl.: H03K 17/081

(54) **SWITCH CIRCUIT, CHARGING CIRCUIT, ELECTRONIC DEVICE, AND CHARGING APPARATUS**

(30) Priority: 30.01.2024 CN 202410131758
(71) Applicant: Huawei Technologies Co., Ltd., Shenzhen, Guangdong 518129 (CN)
(72) Inventor: FU, Yu, Shenzhen, Guangdong 518129 (CN); FAN, Kai, Shenzhen, Guangdong 518129 (CN)
(74) Representative: Huawei European IPR
(86) International application number: PCT/CN2025/073010
(87) International publication number: WO 2025/162001

(57) **Abstract**

This application provides a switch circuit, a charging circuit, an electronic device, and a charging apparatus. The switch circuit includes: a series circuit, including a first transistor and N second transistors that are connected in series, where a second terminal of the first transistor is a second terminal of the series circuit, a control electrode of the first transistor receives a control signal, and a first terminal of an N^{th} second transistor is a first terminal of the series circuit; a first clamping circuit, including diodes connected in series, where terminals and a common connection point of the first clamping circuit are connected to control electrodes of the transistors in the series circuit, and when the series circuit is connected, the first clamping circuit clamps control electrode potentials of the transistors in the series circuit based on the control signal; a second clamping circuit, including a plurality of resistors connected in series, where a first terminal of the second clamping circuit is connected to the first terminal of the series circuit, and when the series circuit is disconnected, the second clamping circuit is configured to clamp control electrodes of the N second transistors. According to the technical solutions provided in embodiments of this application, a withstand voltage requirement of a single transistor can be reduced.

## Description

This application claims priority to Chinese Patent Application No. 202410131758.2, filed with China National Intellectual Property Administration on January 30, 2024 and entitled "SWITCH CIRCUIT, CHARGING CIRCUIT, ELECTRONIC DEVICE, AND CHARGING APPARATUS", which is incorporated herein by reference in its entirety.

### TECHNICAL FIELD

This application relates to the circuit field, and more specifically, to a switch circuit, a charging circuit, an electronic device, and a charging apparatus.

### BACKGROUND

With the development of consumer electronic products such as mobile phones, tablet computers, and notebook computers, people's requirements for wired/wireless charging power of electronic products are gradually increasing, and a charging voltage is increased from 5 V to 20 V, 40 V, 70 V, or even higher.

A charging link usually includes a switch circuit, and the switch circuit controls disconnection and connection of the link by using a transistor. As charging voltages increase in various charging scenarios, the switch circuit needs to withstand increasingly high voltages.

To meet a higher withstand voltage requirement, a transistor with a higher withstand voltage capability needs to be selected. However, a transistor with a high withstand voltage capability has a greater height, and a component thickness of the transistor may not meet the requirement.

### SUMMARY

This application provides a switch circuit, a charging circuit, an electronic device, and a charging apparatus, to improve a withstand voltage capability of a circuit while reducing a height of a component.

According to a first aspect, a switch circuit is provided, including: a series circuit, a first clamping circuit, and a second clamping circuit. The series circuit includes a first transistor and N second transistors that are sequentially connected in series, where N≥1, a second terminal of the first transistor is a second terminal of the series circuit, a first terminal of the first transistor is sequentially connected to the N second transistors, a control electrode of the first transistor is configured to receive a control signal, and a first terminal of an N^{th} second transistor is a first terminal of the series circuit. The first clamping circuit includes at least one diode sequentially connected in series, terminals and a common connection point of the first clamping circuit are connected to control electrodes of the N second transistors and the control electrode of the first transistor, a second terminal of a first diode is the second terminal of the first clamping circuit and is connected to the control electrode of the first transistor, and a first terminal of a last diode is a first terminal of the first clamping circuit and is connected to a control electrode of the N^{th} second transistor. When the control signal enables the series circuit to be connected, the first clamping circuit is configured to clamp control electrode potentials of the first transistor and the N second transistors based on the control signal. The second clamping circuit includes a plurality of resistors sequentially connected in series, a first terminal of the second clamping circuit is connected to the first terminal of the series circuit, and when the control signal enables the series circuit to be disconnected, the second clamping circuit is configured to clamp the control electrodes of the N second transistors.

The transistors may be field effect transistors FETs, or may be bipolar junction transistors BJTs. For an FET, a control electrode is a gate of the transistor, and a first terminal and a second terminal may be a source and a drain of the transistor, or the first terminal and the second terminal may be the drain and the source of the transistor. For a BJT, a control electrode may be a base of the transistor, and a first terminal and a second terminal may be respectively an emitter and a collector of the transistor, or the first terminal and the second terminal may be respectively the collector and the emitter of the transistor.

In this embodiment, a power supply voltage of the switch circuit is distributed on a plurality of transistors, so that a voltage borne by a single transistor is low, thereby reducing a possibility that the transistor is burnt due to overvoltage. In addition, a withstand voltage requirement of a single transistor is reduced, so that a height of the transistor can be reduced, and when the switch circuit is configured in an electronic device or another charging apparatus, the device is light, thin, and miniaturized.

With reference to the first aspect, in some implementations of the first aspect, the transistors in the series circuit are metal oxide semiconductor field effect transistors MOSFETs.

With reference to the first aspect, in some implementations of the first aspect, the transistors in the series circuit are N-channel MOSFETs.

For an N-channel MOSFET, a switch circuit may be turned on or connected by inputting a high level via a control signal, and the switch circuit may be cut off or disconnected by inputting a low level via the control signal.

In some embodiments, the transistors in the series circuit may alternatively be P-channel MOSFETs.

With reference to the first aspect, in some implementations of the first aspect, N≥2, and directions of body diodes of the first transistor and the N second transistors are opposite. The first clamping circuit includes N-1 diodes, the first terminal of the first clamping circuit and common connection points of the diodes in the first clamping circuit are respectively connected to control electrodes of the N^{th} second transistor to a 2^{nd} second transistor, and the second terminal of the first clamping circuit is connected to control electrodes of the first transistor and a 1^{st} second transistor. The second clamping circuit includes N resistors, common connection points of the N resistors are sequentially connected to the control electrodes of the N^{th} second transistor to the 2^{nd} second transistor, and a second terminal of the second clamping circuit is connected to the second terminal of the series circuit.

In this embodiment, the directions of the body diodes of the first transistor and the second transistors are opposite, so that when a power supply is an alternating current power supply, no current backflow is caused to damage a component in the switch circuit.

When the switch circuit is in a disconnected state, a function of the body diode of the first transistor may enable a voltage difference between two terminals of the first transistor to be an on-state voltage drop of the body diode. The power supply voltage may be distributed to a plurality of second transistors, and a ratio of distribution may be positively correlated with resistance values of the resistors in the second clamping circuit.

In some embodiments, the first clamping circuit may include N diodes, so that N-1 common connection points and two terminals of the N transistors can be respectively connected to the control electrodes of the first transistor and the N second transistors.

In some embodiments, the second terminal of the second clamping circuit may alternatively be connected to a common connection point between the 1^{st} second transistor and the first transistor, or may be connected to the control electrode of the 1^{st} second transistor. This is not limited in this application.

With reference to the first aspect, in some implementations of the first aspect, a ratio of resistance values of the N resistors is the same as a ratio of withstand voltage values of the N second transistors.

In some embodiments, if a parasitic capacitance of the transistor is large, a parasitic capacitance of the N^{th} second transistor and an N^{th} resistor may be connected in parallel, so that a voltage across two terminals of the N^{th} second transistor is low. A resistance value of a resistor connected to a last second transistor may be appropriately increased, so that distribution of the power supply voltage is more proper.

With reference to the first aspect, in some implementations of the first aspect, a second terminal of a first resistor is the second terminal of the second clamping circuit, a first terminal of the N^{th} resistor is the first terminal of the second clamping circuit, the N second transistors have a same withstand voltage value, and a resistance value of the first resistor is greater than a resistance value of another resistor in the second clamping circuit.

After the parasitic capacitance is connected to the first resistor in parallel, impact on voltage division is large, and the resistance value of the first resistor may be increased, thereby reducing impact on voltage division.

When the withstand voltage values of the N transistors are different, a resistance value of the N^{th} resistor may be greater than a first value, where the first value is the resistance value of the N^{th} resistor obtained through calculation based on a ratio of withstand voltage values of the N^{th} second transistor to the 1^{st} second transistor.

With reference to the first aspect, in some implementations of the first aspect, directions of body diodes of the first transistor and the N second transistors are the same. The first clamping circuit includes N diodes, and the terminals and the common connection point of the first clamping circuit are sequentially connected to the control electrodes of the first transistor and the N second transistors. The second clamping circuit includes N+1 resistors, common connection points of the N+1 resistors are sequentially connected to the control electrodes of the N second transistors, and a second terminal of the second clamping circuit is connected to the second terminal of the series circuit.

In this embodiment, when the switch circuit is in a disconnected state, the power supply voltage may be distributed to the N second transistors and the first transistor. The second terminal of the second clamping circuit may alternatively be connected to the control electrode of the first transistor.

With reference to the first aspect, in some implementations of the first aspect, the transistors in the series circuit are bipolar junction transistors BJTs.

With reference to the first aspect, in some implementations of the first aspect, the transistors in the series circuit are NPN-type BJTs.

Optionally, the transistors may alternatively be PNP-type transistors.

With reference to the first aspect, in some implementations of the first aspect, a ratio of resistance values of the N+1 resistors is the same as a ratio of withstand voltage values of the N second transistors and the first transistor.

That is, the ratio of the resistance values of the N+1 resistors is equal to a ratio of withstand voltage values of N+1 transistors.

According to a second aspect, a charging circuit is provided, including the switch circuit according to the first aspect or any implementation of the first aspect.

According to a third aspect, an electronic device is provided, including the switch circuit according to the first aspect or any implementation of the first aspect or the charging circuit according to the second aspect.

According to a fourth aspect, a charging apparatus is provided, including the switch circuit according to the first aspect or any implementation of the first aspect or the charging circuit according to the second aspect.

### BRIEF DESCRIPTION OF DRAWINGS

FIG. 1 is a diagram of a structure of a switch circuit;
FIG. 2 is a diagram of a structure of a switch circuit according to an embodiment of this application;
FIG. 3 is a diagram of an equivalent circuit when a switch circuit is connected according to an embodiment of this application;
FIG. 4 is a diagram of a structure of a switch circuit according to an embodiment of this application;
FIG. 5 is a diagram of a structure of a switch circuit according to an embodiment of this application;
FIG. 6 is a diagram of a structure of a switch circuit according to an embodiment of this application; and
FIG. 7 is a diagram of a structure of a switch circuit according to an embodiment of this application.

### DESCRIPTION OF EMBODIMENTS

To make the objectives, technical solutions, and advantages of this application clearer, the following clearly describes the technical solutions in this application with reference to the drawings in this application. It is clear that the described embodiments are merely a part rather than all of embodiments of this application. Based on embodiments of this application, all other embodiments obtained by a person of ordinary skill in the art without creative efforts shall fall within the protection scope of this application.

In the specification, embodiments, claims, and drawings of this application, terms "first", "second", and the like are merely used for the purpose of distinguishing descriptions, and shall not be understood as indicating or implying relative importance, or shall not be understood as indicating or implying a sequence. Words similar to "connect", "connected", and the like are used to express interworking or mutual interaction between different components, and may include a connection, a direct connection, an indirect connection through another component, and the like. In addition, the terms "include", "have", and any variant thereof are intended to cover non-exclusive inclusion, for example, include a series of steps or units. For example, a method, system, product, or device is not necessarily limited to those steps or units expressly listed, but may include other steps or units not expressly listed or inherent to such a process, method, product, or device.

It should be understood that, in this application, "at least one (item)" means one or more, and "a plurality of" means two or more. "And/or" is used for describing an association relationship between associated objects and indicating that three relationships may exist. For example, "A and/or B" may indicate the following three cases: Only A exists, only B exists, and both A and B exist, where A and B may be singular or plural. The character "/" usually indicates an "or" relationship between the associated objects. The expression "at least one of the following items (pieces)" or a similar expression means any combination of these items, including a single item (piece) or any combination of a plurality of items (pieces). For example, at least one of a, b, or c may indicate a, b, c, "a and b", "a and c", "b and c", or "a, b, and c", where a, b, and c may be singular or plural.

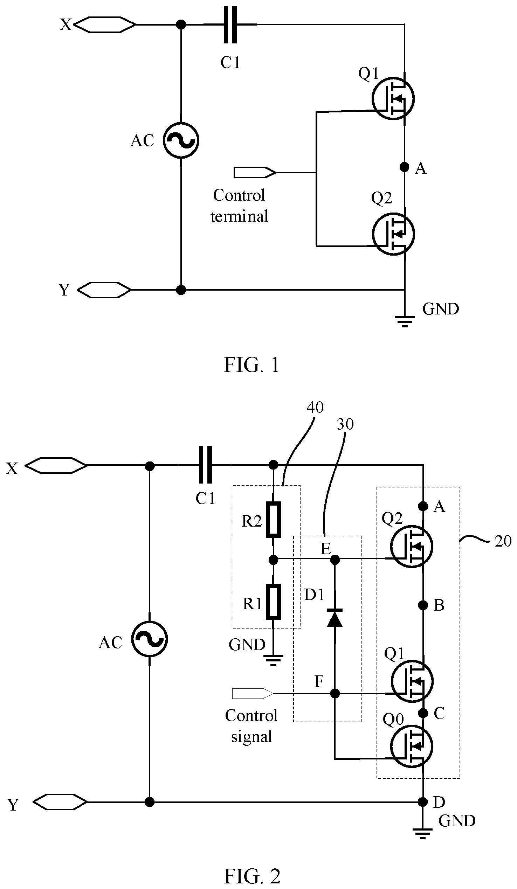

FIG. 1 is a diagram of a structure of a switch circuit. As shown in FIG. 1, the switch circuit includes a capacitor C1, a transistor Q1, and a transistor Q2. Directions of body diodes of the transistor Q1 and the transistor Q2 are opposite, and the switch circuit can control connection and disconnection of a link between a port X and a port Y.

When a control terminal outputs a high level, Q1 and Q2 are turned on. On-resistances of the transistors Q1 and Q2 are small, and are usually at a milliohm (mohm) level, so that an on-state voltage drop is small.

When the control terminal outputs a low level, Q1 and Q2 are cut off, and a level of a point A is pulled to a ground level 0 V due to a function of the body diode of Q2.

Assuming that a power supply voltage is 70 V, when the control terminal inputs a low level, the power supply voltage 70 V is borne by the transistor Q1, for example, a voltage withstanding capability of Q1 may reach 90 V. However, a transistor that can withstand a voltage higher than 50 V is rarely used in a terminal product, and a component height of a high withstand voltage transistor cannot meet a requirement for lightness and thinness of a consumer electronic product.

Embodiments of this application provide a switch circuit, so that a withstand voltage capability of the switch circuit can be improved while a height of a component is reduced.

FIG. 2 is a diagram of a structure of a switch circuit according to an embodiment of this application. As shown in FIG. 2, the switch circuit includes a series circuit 20, a first clamping circuit 30, and a second clamping circuit 40.

The series circuit 20 includes a first transistor Q0 and two second transistors Q1 and Q2 that are connected in series. A drain of the transistor Q2 is a first terminal of the series circuit, and a source of the transistor Q2 is connected to a drain of the transistor Q1. A source of the transistor Q1 is connected to a source of the transistor Q0, and a drain of the transistor Q0 is a second terminal of the series circuit.

The first clamping circuit 30 includes a diode D1. A cathode of the diode D1 is a first terminal of the first clamping circuit 30, and is connected to a gate of the transistor Q2. An anode of the diode D1 is a second terminal of the first clamping circuit 30, and is configured to input a control signal and connect to gates of the transistor Q1 and the transistor Q0.

The second clamping circuit 40 includes two voltage divider resistors R1 and R2. A first terminal of the resistor R2 is a first terminal of the second clamping circuit 40, and is connected to the first terminal of the series circuit 20. A second terminal of the resistor R2 is connected to a first terminal of the resistor R1 and the gate of the transistor Q2. A second terminal of the resistor R1 is connected to the second terminal of the series circuit 20. Resistance values of the voltage divider resistors R1 and R2 may be approximately at magnitudes from kilohms (KΩ) to hundreds of kilohms, or may be higher or lower, for example, hundreds of ohms. This is not limited in this application.

The control signal may be at a high level V_{H} or a low level V_{L}, so as to control a connected or disconnected state of the entire switch circuit. For example, each transistor in FIG. 2 is an N-type transistor. For example, when the control signal inputs a high level, two terminals of the series circuit 20 are connected, and the entire switch circuit is in the connected state; and when the control signal inputs a low level, the two terminals of the series circuit 20 are disconnected, and the entire switch circuit is in the disconnected state. For example, when each transistor is an N-channel transistor, the high level V_{H} of the control signal may be 5 V, the low level V_{L} may be 0 V, and the high level or the low level of the control signal may be another value, for example, 3 V, 8 V, or a higher or lower level, provided that the high level value can enable the first transistor Q0 and the second transistor Q1 and the second transistor Q2 to be turned on, and the low level value can enable the transistors mentioned above to be cut off. This is not limited in this application.

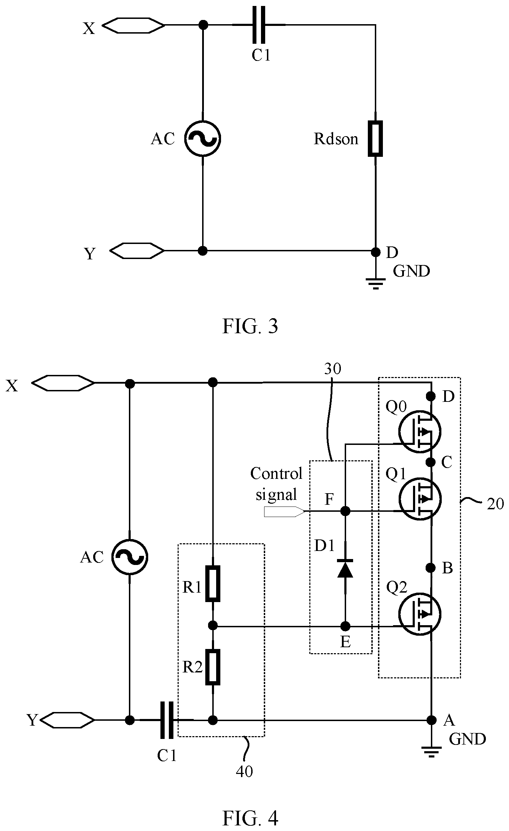

When the control signal is at the high level V_{H}, the transistor Q0 is turned on, a potential of a point C is pulled down, a voltage difference between the gate and the source of Q1 increases. When the voltage difference reaches a threshold voltage of Q1, Q1 is also turned on. A potential of a point E is pulled up through the diode D1 to a value that differs from a value of a point F by Uon, where Uon is a positive on-state voltage drop of the diode D1, and is generally 0.6-0.7 V for a silicon diode and 0.2-0.3 V for a germanium diode. A potential of a point B is pulled down because Q1 is turned on, a voltage difference between the gate and the source of Q2 increases, and Q2 is also turned on. In this way, a voltage applied by a power supply voltage to the switch circuit is borne by the capacitor C1 and the series circuit 20. As shown in FIG. 3, in this case, the three transistors may be equivalent to a resistance Rdson that is an on-resistance of the three transistors. Because on-resistances of the transistors Q0, Q1, and Q2 are small, and are generally at a milliohm (mohm) level, and a capacitive reactance of the capacitor C1 is generally far greater than the on-resistance Rdson of the three transistors, so that most of a voltage applied by an alternating current power supply AC to the switch circuit is borne by the capacitor C1, and the voltage borne by the three transistors is generally small when the switch circuit is in the connected state.

When the control signal is at the low level V_{L}, the transistor Q0 is cut off. However, because a current direction of a body diode (the body diode may also be referred to as a parasitic diode) of Q0 is a direction from the point C to the point D, the potential of the point C is still pulled down, and is slightly higher than a ground voltage (a difference is a positive on-state voltage drop of the body diode of the transistor Q0). In this case, the diode D1 is cut off, the transistors Q1 and Q2 are cut off, and the power supply voltage is borne by the transistors Q1 and Q2.

When the transistors Q1 and Q2 have a same withstand voltage degree, the resistors R1 and R2 may be completely equal. When the positive on-state voltage drop of the body diode of the transistor Q0 is not considered, the power supply voltage may be evenly distributed to the transistors Q1 and Q2.

Specifically, using an example in which an instantaneous power supply voltage is 70 V, a voltage at the point A is 70 V. Because the resistors R1 and R2 are equal, a voltage at the point E is 35 V, and the transistor Q2 is in the off state. When a voltage at the point B decreases due to power fluctuation or individual differences of the transistors, a gate-source voltage difference V_{EB} of the transistor Q2 is greater than 0, the transistor Q2 is slowly turned on, and a current flows from the point A to the point B. In this case, the voltage at the point B increases, and negative feedback is formed. Therefore, V_{EB} decreases until 0 V, and the transistor Q2 is cut off again. When the voltage at the point B increases, the transistor Q2 is slowly cut off, and the voltage at the point B decreases under an effect of the negative feedback. Therefore, for the transistor Q2, the voltage at the point B always follows the voltage at the point E, so that a source-drain voltage difference of the transistor Q2 is 35 V. When a positive on-state voltage drop of the body diode of the transistor Q0 is ignored, the potential at the point C is 0 V, and the source-drain voltage difference of the transistor Q2 is also 35 V.

According to the technical solution described in this embodiment of this application, the power supply voltage is evenly distributed to the second transistors, and voltage division of the power supply voltage is not uneven due to a manufacturing process difference of the second transistors or fluctuation of the power supply voltage. Under a specific power supply voltage requirement, a withstand voltage requirement of a single transistor can be reduced. When the withstand voltage of the transistor is reduced, a height of a component can also be properly reduced, so that the switch circuit meets a requirement of lightness and thinness of an electronic device or another device.

In this embodiment of this application, the first transistor Q0 and the second transistors Q1 and Q2 may be N-channel transistors, for example, may be bipolar junction transistors (bipolar junction transistor, BJT) or field effect transistors (field effect transistor, FET). When Q0, Q1, and Q2 are BJTs, they may be PNP-type or NPN-type transistors. When Q0, Q1, and Q2 are FETs, they may be metal oxide semiconductor field effect transistors (metal oxide semiconductor FET, MOSFET), for example, may be enhancement MOSFETs or depletion MOSFETs, or may be junction FETs (junction FET, JFET).

In FIG. 2, an example in which the first transistor Q0 and the second transistors Q1 and Q2 are N-channel MOS transistors is used to describe the technical solution in this embodiment of this application. As described above, when the transistors in the switch circuit are N-channel transistors or NPN-type transistors, the control signal inputting the high level can enable the switch circuit to be in the connected or on state, and the control signal inputting the low level can enable the switch circuit to be in the disconnected or off state.

In some embodiments, the first transistor Q0 and the second transistors Q1 and Q2 may alternatively be P-channel MOS transistors. In this case, the control signal inputting the low level can enable the switch circuit to be in the connected or on state, and the control signal inputting the high level can enable the switch circuit to be in the disconnected or off state.

FIG. 4 is a diagram of a structure of a switch circuit according to an embodiment of this application by using a P-channel MOS transistor as an example.

A series circuit 20 includes a first transistor Q0 and second transistors Q1 and Q2. A drain (a point A) of the transistor Q2 is a first terminal of the series circuit 20, and a source of the transistor Q2 is connected to a drain of the transistor Q1. A source of the transistor Q1 is connected to a source of the transistor Q0, and a drain of the transistor Q0 is a second terminal (a point D) of the series circuit 20.

A first clamping circuit 30 includes a diode D1. An anode (a point E) of the diode D1 is a first terminal of the first clamping circuit 30 and is connected to a gate of the transistor Q2. A cathode (a point F) of the diode D1 is a second terminal of the first clamping circuit 30 and is configured to input a control signal and connect to gates of the transistor Q1 and the transistor Q0.

A second clamping circuit includes two voltage divider resistors R1 and R2. A first terminal (the point A) of the resistor R2 is a first terminal of the second clamping circuit 40, and a second terminal of the resistor R2 is connected to a first terminal of the resistor R1 and the gate of the transistor Q2. A second terminal (the point D) of the resistor R1 is a second terminal of the second clamping circuit 30 and is connected to the second terminal of the series circuit 20.

When the control signal inputs a low level, the transistor Q0 is turned on, a potential of the point C is pulled up, Q1 is turned on, a potential of the point B is pulled up, the diode D1 is turned on, and a potential of the point E is pulled down. Therefore, an absolute value of a gate-source voltage difference of the transistor Q2 is increased, and the transistor Q2 is also turned on. The three transistors may be equivalent to an on-resistance. Because a value of the on-resistance is small, most of a power supply voltage is borne by a capacitor C1.

When the control signal inputs a high level, the transistors Q0 and Q1 are cut off, and D1 is cut off. The potential of the point E is determined by resistance values of R2 and R1. Assuming that an instantaneous power supply voltage is 70 V and the resistance values of R1 and R2 are equal, the potential of the point E is 35 V. Similar to the transistor being an N-channel transistor, the potential of the point C follows a potential of the point F, and the potential of the point B follows the potential of the point E, so that the second transistors Q1 and Q2 evenly share the power supply voltage, and a source-drain withstand voltage requirement of a single transistor can be reduced.

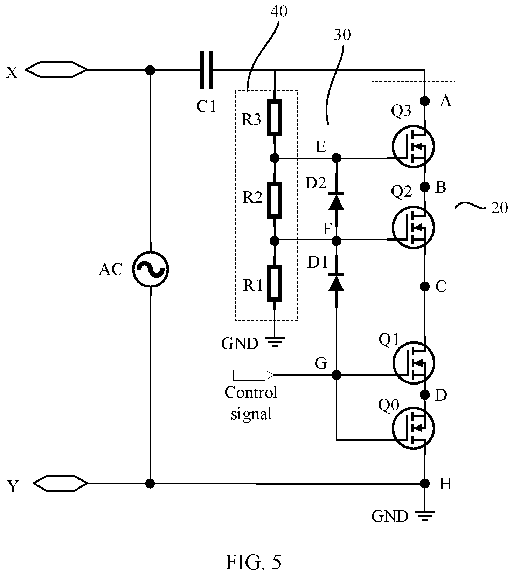

It should be understood that the second transistors in FIG. 2 include Q1 and Q2. In some embodiments, a quantity of second transistors may be further increased, so that more transistors jointly bear a power supply voltage, and a withstand voltage requirement of a single transistor is reduced. FIG. 5 is a diagram of a structure of a switch circuit according to an embodiment of this application by using an example in which there are three second transistors.

As shown in FIG. 5, a series circuit 20 includes a first transistor Q0 and second transistors Q1, Q2, and Q3. A drain of the transistor Q2 is connected to a source of the transistor Q3, and a drain of the transistor Q3 is a first terminal of the series circuit 20. A first clamping circuit 30 includes diodes D1 and D2. A cathode of the diode D2 is a first terminal of the first clamping circuit 30 and is connected to a gate of the transistor Q3. An anode of the diode D2 is connected to a cathode of the diode D1 and a gate of the transistor Q2. An anode of the diode D1 is a second terminal of the first clamping circuit 30 and is connected to gates of the transistor Q1 and Q0. A second clamping circuit 40 includes resistors R1, R2, and R3, where a first terminal of R3 is a first terminal of the second clamping circuit 40, and a second terminal of R1 is a second terminal of the second clamping circuit 40.

When a control signal inputs a low level, similar to the case in which there are two second transistors, a potential of a point B follows a potential of a point E, a potential of a point C follows a potential of a point F, and a potential of a point D follows a potential of a point G. When R1, R2, and R3 are equal, a power supply voltage may be evenly distributed to the second transistors Q1, Q2, and Q3. Therefore, a source-drain withstand voltage requirement of each second transistor can be appropriately reduced.

It can be learned from the foregoing description that, when there are more second transistors, more voltage divider resistors and diodes may be disposed in the switch circuit, so that the power supply voltage can be borne by more transistors, and the withstand voltage requirement for a single transistor can be reduced.

Specifically, using the N-channel transistors shown in FIG. 2 and FIG. 5 as an example, the series circuit may include a first transistor Q0 and N second transistors Q1, Q2, ..., and QN. In this case, Q0 may be sequentially connected in series to Q1, Q2, until QN, a drain of QN is the first terminal of the series circuit, and a drain of Q0 is the second terminal of the series circuit.

The first clamping circuit may include N-1 diodes that are sequentially connected in series, a cathode of an (N-1)^{th} diode may be the first terminal of the first clamping circuit, an anode of a first diode may be the second terminal of the first clamping circuit, and the first terminal and N-2 common connection points (a node between any two diodes) may be sequentially connected to gates of an N^{th} second transistor to a 2^{nd} second transistor, and the second terminal may be connected to gates of a 1^{st} second transistor and the first transistor, and may receive the control signal. The first clamping circuit may transmit the control signal to control electrodes (gates or bases) of the second transistors in sequence by using the first clamping circuit when the control signal outputs a valid level (a high level is valid for an N-channel transistor or an NPN transistor, and a low level is valid for a P-channel transistor or a PNP transistor).

The second clamping circuit may include N resistors connected in series, where a first terminal of an N^{th} resistor is the first terminal of the second clamping circuit and is connected to the first terminal of the series circuit. A second terminal of a first resistor is the second terminal of the second clamping circuit, and is connected to the second terminal of the series circuit. N-1 common connection points (a node between any two resistors) formed by N resistors may be sequentially connected to gates of the N^{th} second transistor to the 2^{nd} second transistor. When the control signal outputs an invalid level, the second clamping circuit may enable a voltage difference between two terminals of the second clamping circuit to be distributed to each second transistor.

When the control signal inputs a high level, the first transistor and the second transistors are turned on in sequence through the diodes D1 to D(N-1), and gate potentials of the transistors are clamped through the first clamping circuit.

When the control signal inputs a low level, each transistor is cut off, and through the second clamping circuit, the gate potentials of the 2^{nd} second transistor to the N^{th} second transistor are directly clamped by voltage division, a control electrode potential of the 1^{st} second transistor is clamped through the first resistor, and the power supply voltage may be distributed to the N second transistors based on resistance values of the N resistors.

It should be understood that, in FIG. 2, FIG. 4, FIG. 5, or an embodiment in which there are more second transistors, the first transistor and the 1^{st} second transistor may not be directly connected, but a diode may be disposed, and a direction of the diode may be consistent with a direction of another diode in the first clamping circuit. In this way, when the control signal outputs a high level, the gate potentials of the first transistor and the 1^{st} second transistor differ by an on-state voltage drop of one diode, rather than being equal.

In addition, the foregoing describes only that resistance values of voltage divider resistors in the second clamping circuit 40 may be equal when the second transistors have a same withstand voltage capability. Persons skilled in the art can readily appreciate that, when the second transistors have different withstand voltages, the resistance value of the voltage divider resistor may be adjusted based on a ratio of withstand voltages of the second transistors, so that the power supply voltage can be distributed to each second transistor based on a withstand voltage capability, thereby reducing a possibility of burning a single transistor. FIG. 5 is used as an example. For example, if a ratio of highest withstand voltages of the second transistors Q3, Q2, and Q1 is x:y:z, R3:R2:R1=x:y:z may be set, so that the power supply voltage can be distributed to the transistors Q3, Q2, and Q1 based on x:y:z. When there are more second transistors, resistance values of the resistors may also be set based on a ratio of withstand voltage values. When there are more second transistors, for example, when a ratio of highest source-drain withstand voltages of QN ... Q2, and Q1 is VN:...V2:V1, RN:...R2:R1=VN:...V2:V1 may be set.

In the foregoing embodiments, a parasitic capacitance of the transistor is not considered. If the parasitic capacitance of the selected transistor is large and cannot be ignored, and a frequency of a power supply is high, the parasitic capacitance may cause a specific deviation between voltage division of different second transistors and voltage withstand degrees of these second transistors. In this case, values of different resistors in the second clamping circuit may be properly adjusted, so that voltage division of the transistors is positively correlated with a voltage withstand degree.

Still using an example in which the second transistors include three transistors Q1, Q2, and Q3, parasitic capacitances of the transistors include a gate-source capacitance C_{gs}, a gate-drain capacitance C_{gd}, and a drain-source capacitance C_{ds}. In the switch circuit in this embodiment of this application, parasitic capacitances that affect voltage division of the second clamping circuit include the gate-source capacitance C_{gs} and the gate-drain capacitance C_{gd}.

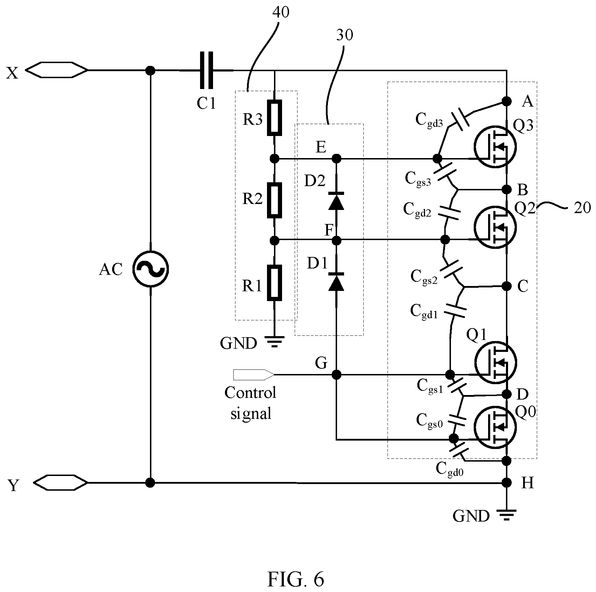

FIG. 6 is a diagram of a structure of a switch circuit when a parasitic capacitance is considered. A gate-drain capacitance C_{gd3} of a 3rd second transistor Q3 affects voltage division of a third resistor R3, and a gate-source capacitance C_{gs3} of the 3rd second transistor Q3 and a gate-drain capacitance C_{gd2} of a 2^{nd} second transistor Q2 affect voltage division of a second resistor R2 ... C_{gd3} is directly connected to R3 in parallel to perform voltage division, and other parasitic capacitances are each formed by two capacitances connected in series and then are connected to the corresponding resistors in parallel. Generally, a gate-source voltage of a transistor is small. Therefore, except that impact on voltage division of R3 is large, impact on voltage division of another resistor is small. Therefore, to reduce the parasitic capacitance causing the power supply voltage to make voltage division of the second transistor inappropriate, a resistance value of the third resistor R3 may be appropriately increased or a resistance value of another resistor may be reduced, so that a voltage division proportion of each second transistor is close to a withstand voltage value of the second transistor, thereby reducing a possibility of burning the transistor and increasing a lifetime of the transistor. For example, (R3|| C_{gs3}):R2:R1=V_{Q3}:V_{Q2}:V_{Q1}, where V_{Q3}, V_{Q2}, and V_{Q1} are respectively maximum source-drain withstand voltages of the transistors Q3, Q2, and Q1, R3|| C_{gs3} is a total impedance Z after the parallel connection, and Z may satisfy the following formula: $Z = \frac{1}{\frac{1}{R 3} + \frac{1}{{jωC}_{gs 3}}}$ *ω* is a frequency of the power supply voltage, and j is an imaginary part symbol.

To facilitate adjustment of the resistor, for example, in an embodiment, the resistor R3 may be a variable resistor, so as to facilitate adjustment of voltage division of each second transistor.

Certainly, it is also possible to not only consider impact of the parasitic capacitance affecting a last second transistor on voltage division of a last resistor, but also consider impact of another parasitic capacitance on voltage division of another resistor. In this way, the resistors may be set as adjustable resistors, thereby facilitating precise control of voltage division of each second transistor.

In embodiments of FIG. 2, FIG. 4, and FIG. 5, directions of body diodes of the first transistor and the second transistors in the series circuit are opposite, so that when a power supply is an alternating current power supply, a current backflow is avoided. In addition, when the switch circuit is in the off state, the on-state voltage drop of the first transistor is the on-state voltage drop of the body diode of the first transistor, and the power supply voltage is basically borne by the second transistor.

When the power supply is the alternating current power supply, a maximum value of the power supply voltage may be a value such as 70 V, 50 V, 20 V, or 100 V. This is not limited in this application.

When the current backflow impact is not considered or the current backflow problem does not exist, for example, when the transistor is a BJT or the power supply of the switch circuit is a direct current power supply, the current backflow problem does not exist, and a structure of the switch circuit may be different from that described above.

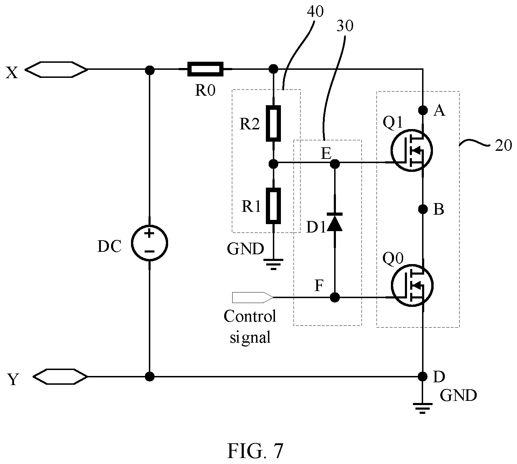

For example, a transistor in a series circuit is still an N-channel MOS transistor, and a power supply of a switch circuit is a direct current power supply. FIG. 7 is a diagram of a structure of a switch circuit according to an embodiment of this application. As shown in FIG. 7, a series circuit 20 includes a first transistor Q0 and a second transistor Q1, and directions of body diodes of the two transistors are the same. A first clamping circuit 30 includes a diode D1, and two terminals of the diode D1 are respectively connected to gates of the first transistor Q0 and the second transistor Q1. A second clamping circuit 40 includes resistors R1 and R2, and a common connection point of the two resistors is connected to the gate of the second transistor Q1.

When a control signal provides a high level, the first transistor Q0 is turned on, a potential of a point B is pulled down, the diode D1 is turned on, a potential of a point E is pulled up, a gate-source voltage difference of the second transistor Q1 is increased, and Q1 is turned on. A power supply voltage of the entire switch circuit is borne by a resistor R0 and the two transistors. The resistor R0 may be a protection resistor of the switch circuit, and a resistance value of R0 may be far greater than on-resistances of the two transistors, so that most of the power supply voltage is borne by the resistor R0.

When the control signal provides a low level, the first transistor Q0 is cut off, D1 is cut off, the second transistor Q1 is cut off, the series circuit is disconnected, and the power supply voltage of the switch circuit is borne by the first transistor Q0 and the second transistor Q1. Still using an example in which the power supply voltage is 70 V and resistance values of the two resistors are equal, because of voltage division effects of the two resistors in the second clamping circuit, the potential of the point E is 35 V, the potential of the point B follows the potential of the point E, and the power supply voltage is evenly distributed to the first transistor Q0 and the second transistor Q1.

FIG. 7 shows only one second transistor. When there are N second transistors, the first clamping circuit may include N diodes sequentially connected in series, and two terminals and N-1 common connection points of the first clamping circuit may be sequentially connected to gates of the N second transistors and the first transistor. The second clamping circuit may include N+1 resistors, N-1 common connection points formed by the resistors may be sequentially connected to an N^{th} second transistor to a 2^{nd} second transistor, and two terminals of the second clamping circuit are respectively connected to two terminals of the series circuit. For details of the structure, refer to the foregoing descriptions, and details are not described herein again.

In the switch circuit in FIG. 7, because the power supply voltage is not only borne by the second transistor, but also borne by the first transistor, resistance values of resistors in the second clamping circuit may be set based on highest source-drain withstand voltage values of the second transistor and the first transistor. Specifically, assuming that a ratio of source-drain withstand voltage values of the N second transistors to the source-drain withstand voltage value of the first transistor is: VN:...V2:V1:V0, R(N+1):...R2:R1=VN:...V2:V1:V0 may be set.

It should be understood that the foregoing describes the technical solutions of embodiments of this application by using an example in which the transistor is a MOS transistor. When the transistor is a BJT, a gate may correspond to a base (which may be referred to as a control electrode), an emitter may correspond to a source, and a collector corresponds to a drain. When the first transistor and the second transistor are BJTs, there is no current backflow problem, and the structure of the switch circuit may be shown in FIG. 7.

When parasitic capacitances of the BJT transistors are considered, the parasitic capacitances that may affect voltage division of the transistors include a parasitic capacitance between the base and the emitter and a capacitance between the base and the collector. For details, refer to the foregoing descriptions, and details are not described herein again.

It should be further understood that, when the transistors are BJTs, only one parasitic capacitance is connected in parallel to a first resistor and a last resistor, and therefore, voltage division of the first transistor and the N^{th} second transistor is greatly affected. Resistance values of the first resistor and the last resistor may be appropriately increased, or a resistance value of another resistor may be appropriately decreased. For details, refer to the foregoing descriptions, and details are not described herein again.

In addition, it may be understood that each transistor in embodiments of this application may be a single transistor, or may be formed by a plurality of transistors connected in series or in parallel. This is not limited in this application. In actual manufacturing, the transistor may be designed based on requirement of each transistor. In addition, the MOS transistor has two electrodes (the first terminal and the second terminal) other than the gate, one is the source, and the other is the drain. The two electrodes are not clearly distinguished. For example, the first terminal is the source, and the second terminal is the drain; or the first terminal is the drain, and the second terminal is the source. For the BJT, in addition to the base, a distinction between the emitter and the collector is not clearly defined either.

An embodiment of this application further provides a charging circuit, including any switch circuit described above.

An embodiment of this application further provides an electronic device, including any switch circuit described above or a charging circuit.

The electronic device may be a terminal device such as a mobile phone, a computer, a tablet computer, a notebook computer, an in-vehicle computer, a smartwatch, or a smart band.

An embodiment of this application further provides a charging apparatus, including any switch circuit described above or a charging circuit.

The charging apparatus may be a charger, for example, may be a device such as a wired charger or a wireless charger.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A switch circuit, comprising: a series circuit, a first clamping circuit, and a second clamping circuit, wherein:
the series circuit comprises a first transistor and N second transistors that are sequentially connected in series, N≥1, a second terminal of the first transistor is a second terminal of the series circuit, a first terminal of the first transistor is sequentially connected to the N second transistors, a control electrode of the first transistor is configured to receive a control signal, and a first terminal of an N^{th} second transistor is a first terminal of the series circuit;
the first clamping circuit comprises at least one diode sequentially connected in series, terminals and a common connection point of the first clamping circuit are connected to control electrodes of the N second transistors and the control electrode of the first transistor, a second terminal of a first diode is a second terminal of the first clamping circuit and is connected to the control electrode of the first transistor, and a first terminal of a last diode is a first terminal of the first clamping circuit and is connected to a control electrode of the N^{th} second transistor; and when the control signal enables the series circuit to be connected, the first clamping circuit is configured to clamp control electrode potentials of the first transistor and the N second transistors based on the control signal; and
the second clamping circuit comprises a plurality of resistors sequentially connected in series, a first terminal of the second clamping circuit is connected to the first terminal of the series circuit, and when the control signal enables the series circuit to be disconnected, the second clamping circuit is configured to clamp the control electrodes of the N second transistors.

2. The switch circuit according to claim 1, wherein the transistors in the series circuit are metal oxide semiconductor field effect transistors MOSFETs.

3. The switch circuit according to claim 1 or 2, wherein the transistors in the series circuit are N-channel MOSFETs.

4. The switch circuit according to claim 3, wherein N≥2, and directions of body diodes of the first transistor and the N second transistors are opposite;
the first clamping circuit comprises N-1 diodes, the first terminal of the first clamping circuit and common connection points of the diodes in the first clamping circuit are respectively connected to control electrodes of the N^{th} second transistor to a 2^{nd} second transistor, and the second terminal of the first clamping circuit is connected to control electrodes of the first transistor and a 1^{st} second transistor; and
the second clamping circuit comprises N resistors, common connection points of the N resistors are sequentially connected to the control electrodes of the N^{th} second transistor to the 2^{nd} second transistor, and a second terminal of the second clamping circuit is connected to the second terminal of the series circuit.

5. The switch circuit according to claim 4, wherein a ratio of resistance values of the N resistors is the same as a ratio of withstand voltage values of the N second transistors.

6. The switch circuit according to claim 4, wherein a second terminal of a first resistor is the second terminal of the second clamping circuit, a first terminal of an N^{th} resistor is the first terminal of the second clamping circuit, the N second transistors have a same withstand voltage value, and a resistance value of the first resistor is greater than a resistance value of another resistor in the second clamping circuit.

7. The switch circuit according to claim 3, wherein directions of body diodes of the first transistor and the N second transistors are the same;
the first clamping circuit comprises N diodes, and the terminals and the common connection point of the first clamping circuit are sequentially connected to the control electrodes of the first transistor and the N second transistors; and
the second clamping circuit comprises N+1 resistors, common connection points of the N+1 resistors are sequentially connected to the control electrodes of the N second transistors, and a second terminal of the second clamping circuit is connected to the second terminal of the series circuit.

8. The switch circuit according to claim 1, wherein the transistors in the series circuit are bipolar junction transistors BJTs.

9. The switch circuit according to claim 8, wherein the transistors in the series circuit are NPN-type BJTs.

10. The switch circuit according to claim 9, wherein a ratio of resistance values of the N+1 resistors is the same as a ratio of withstand voltage values of the N second transistors and the first transistor.

11. A charging circuit, comprising the switch circuit according to any one of claims 1 to 10.

12. An electronic device, comprising the switch circuit according to any one of claims 1 to 10 or the charging circuit according to claim 11.

13. A charging apparatus, comprising the switch circuit according to any one of claims 1 to 10 or the charging circuit according to claim 11.
